**Europäisches Patentamt**

**European Patent Office**

**Office européen des brevets**

(19)

(11) Veröffentlichungsnummer: **0 162 146 B1**

(12)

# EUROPÄISCHE PATENTSCHRIFT

(45) Veröffentlichungstag der Patentschrift:
**11.05.88**

(51) Int. Cl.⁴: **H 05 K 9/00**

(21) Anmeldenummer: **84115745.6**

(22) Anmeldetag: **18.12.84**

(54) Geschirmter Schrank Mit Filterbaugruppen.

(30) Priorität: **19.04.84 DE 3415025**

(43) Veröffentlichungstag der Anmeldung:
**27.11.85 Patentblatt 85/48**

(45) Bekanntmachung des Hinweises auf die Patenterteilung:
**11.05.88 Patentblatt 88/19**

(84) Benannte Vertragsstaaten:
**BE CH DE FR GB IT LI NL**

(56) Entgegenhaltungen:
**LU - A - 67 628**

(73) Patentinhaber: **Siemens Aktiengesellschaft Berlin und München, Wittelsbacherplatz 2, D-8000 München 2 (DE)**

(72) Erfinder: **Dirmeyer, Josef, Dipl.-Ing.(FH), Neuenschwand 64, D-8465 Bodenwöhr (DE)**
Erfinder: **Sammet, Wolfgang, Dipl.-Ing., Schleslerstrasse 25, D-8400 Regensburg (DE)**

## Beschreibung

Die Erfindung betrifft einen geschirmten Schrank mit Filter-Baugruppen, d.h. einen sog. Filterschrank, der insbesondere für EMP-geschützte und ggf. entstörte Nachrichten- und Steuerleitungen, die zur Einführung in geschirmte Räume und Kabinen bestimmt sind, geeignet ist.

Der zunehmende Einsatz hochempfindlicher Nachrichten- und Messgeräte für hohe Frequenzen bedingt in steigendem Masse die Abschirmung von Räumen gegen elektromagnetische Felder. Ihre besondere Bedeutung erhält diese Schirmung noch zusätzlich durch den immer stärker zunehmenden Einsatz von industriellen HF-Generatoren, mechanischen Hochspannungsgleichrichtern, elektromedizinischen Geräten und ähnlichen Einrichtungen mit teilweise erheblicher Störstrahlenergie.

Je nach den vorliegenden Verhältnissen handelt es sich entweder darum, Räume, in denen empfindliche Messungen durchgeführt oder in die Nachrichten- und Steuersignale störungsfrei eingeleitet werden, gegen von aussen kommende Störfelder wirksam abzuschirmen oder aber störende Anlagen und Apparate in einem geschirmten Raum so unterzubringen, dass ihre Umgebung nicht gestört wird.

Zur Lösung dieser Probleme wurden daher bereits geschirmte Kabinen und Raumabschirmungen mit Schirmungselementen für hohe Anforderungen geschaffen. Insbesondere gelangen hier Metallfolien bzw. Bleche zum Einsatz, die als Wand, Boden und Deckenelemente hochfrequenzdicht miteinander verbunden, insbesondere verschweisst sind. Bei Verwendung dieser Folien und Bleche in geeigneter Materialstärke lässt sich eine beliebig hohe Schirmdämpfung der elektrischen und magnetischen Störkomponente erzielen, vorausgesetzt, die erforderlichen Fenster- und Türkonstruktionen für die geschirmten Kabinen und Räume besitzen die notwendige hochfrequenzdichte Abdichtung ihrer Spalten und Fugen.

Die in die geschirmten Kabinen un d Räume führenden elektrischen Leitungen müssen hochfrequent verriegelt werden, um die hohen Dämpfungseigenschaften der Folien und sonstigen Schirmungselemente voll auszunützen. Da die Dämpfung eines geschirmten Raumes durch das schwächste Glied mitbestimmt wird, kommt dieser Netzverriegelung eine besondere Bedeutung zu. Es wurden daher hochwertige HF-Entstörgeräte in Breitbandausführung entwicklet, die eine wirksame Entstörung bis 35 GHz sicherstellen. Für die störungsfreie Einführung von Nachrichten- und Steuerleitungen in geschirmte Kabinen und Räume stehen Filter zur Verfügung, die aus Einzeldrosseln aufgebaut bzw. mit stromkompensierten Drosseln bestückt sind. Unter der Bezeichnung Filterreihe B 84 311 - ... im Handel erhältliche Siemens-Zweileiter-Filter erfordern pro zu beschaltende Doppelader ein vollständiges, in einem vollgeschirmten Gehäuse untergebrachtes Filter, das wahlweise mit einem Vorsatzgerät für den EMP-Schutz, d.h. für den Überspannungsschutz ausrüstbar ist. Hierzu ist zu bemerken, dass der EMP-Schutz in all den Fällen erforderlich ist, in denen elektrische und elektronische Geräte und Anlagen durch nukleare elektromagnetische Impulse bedroht sind, die bekanntliche Feldgrössen im kV/m - und Ampere/m-Bereich und Impulsanstiegs- bzw. Abfallzeiten von wenigen ns bzw. einigen 100 ns besitzen.

In all diesen Fällen, in denen mit impulsförmigen Überspannungen auf Leitungen zu rechnen ist, deren Amplitude die Stossspannungsfestigkeit der eingesetzten Bauelemente übersteigt, sei es durch atmosphärischen Entladungen, Schalthandlungen, oder durch einen nuklearen elektromagnetischen Impuls (NEMP) kommen Entstörfilter mit integriertem Überspannungsschutz zur Anwendung. Hierfür geeignete elektrische Bauelemente sind z.B. Varistoren, Einzelableiter und 3-Elektrodenableiter.

Beim vorstehend erwähnten Aufbau der bekannten, mit einem EMP-Vorsatz ausrüstbaren Filter ist es aufgrund der im Filtergehäuse angeordneten Durchführungskondensatoren nicht möglich, bei Zusammenfassung mehrerer Filter in einem geschirmten Schrank, einem sog. Filterschrank, auf das in diesem Falle an sich unnötige Schirmgehäuse je Einzelfilter zu verzichten. Zusätzlich sind bei Einsatz dieser bekannten Filter in geschirmten Schränkten auf der Schrankein- und Ausgangsseite Anschlussleisten für die Kundenverkabelung notwendig, die über Kabelbäume sehr aufwendig mit den einzelnen Filtern verbunden werden müssen. Da der EMP-Schutz nur gegeben ist, wenn der hierzu erforderliche EMP-Vorsatz in Kombination mit einem Störfilter betrieben wird, stand bisher auch für Fälle, in denen keine hohen Dämpfungsforderungen, sondern nur ein EMP-Schutz gefordert wurde, ausschliesslich die Kombination eines EMP-Vorsatzgerätes mit einem 100 dB-Filter zur Verfügung.

Ausgehend von den vorgenannten Problemen liegt der Erfindung die Aufgabe zugrunde, einen geschirmten Schrank mit bzw. für Filter-Baugruppen für den EMP-Schutz und ggf. Störungsschutz von Nachrichten- und Steuerleitungen zu schaffen, der unter anderen, folgenden Forderungen genügt:
Gegenüber bisher bekannten geschirmten Schränken soll die vorerwähnte aufwendige Verdrahtung mit entsprechenden Kundenanschlussleisten auf der Schrankein = und Ausgangsseite entfallen und i.ü. in ihrer Vereinfachung so Übersichtlich für den Kunden gestaltet sein, dass die Zahl der möglichen Verdrahtungsfehlerquellen auf ein Minimum herabgesetzt wird. Der Schrank soll zudem so beschaffen sein, dass für nötige Montage- und Verdrahtungsarbeiten genügend Raum zur Verfügung steht.

Insbesondere soll zu diesem Zweck die einzelne Filterbaugruppe gehäusefrei sein und so gerichtete Ein- und Ausgangsanschlussleisten besitzen, dass die Kontakte, nämlich vorzugsweise Schneidklemmkontakte der Anschlussleisten mühelos zugänglich und Baulemente der Filter-Baugruppen leicht und zwar ohne Ausbau der Baugruppen auswechselbar sind.

Ein geschirmten Schrank gemäss dem Oberbegriff des Patentanspruchs 1, der diese Aufgabe löst, zeichnet sich erfindungsgemäss dadurch aus, dass der Schrank durch einen mit den Schrankwänden hochfrequenzdicht verbundenen Rahmen in eine Kabelein- und hochfrequenzdichte Kabelausgangsseite unterteilt ist, dass die Kabeleingangsseite des Schranks durch eine hochfrequenzdichte, lösbare Frontblende abgedeckt ist, dass gegen die Rahmenöffnung hochfrequenzdicht eine um eine Drehachse nach aussen schwenkbare, mit Durchbrechungen ausgebildete Montagewand für die Filterbaugruppen anliegt, dass die einzelnen Filter-Baugruppen gehäusefrei sind und mit ihren Filterausgangsseiten durch die Durchbrechungen geführt und an die Montagewand mittels Flanschen hiochfrequenzdicht angeflanscht sind, die als Träger der Filterbaugruppen dienen und mit Durchführungselementen zur hochfrequenzdichten Verbindung der Filterein- und Ausgangsseiten bestückt sind.

Durch die Schwenkbarkeit der mit den Filter-Baugruppen bestückten Montagewand besteht sowohl auf der Eingangs- als auch Ausgangsseite des Filterschrankes und damit auch in Bezug auf die Filter-Baugruppen eine ausgezeichnete Zugänglichkeit des Kunden zu den Anschlüssen. Durch die so gestaltete Montagewand entfallen im Unterschied zu den bisher üblichen Filterschränken — wie bereits erwähnt — auf der Ein- und Ausgangsseite die zusätzlichen Anschlussleisten mit den Kabelbäumen; d.h. dass keine Verkabelung seitens des Herstellers erforderlich ist.

Eine flexible Kabelzu- und Abführung wird zweckmässigerweise dadurch erreicht, dass am Kopf- und Fussende des Schranks Kabelrangierräume angeordnet sind, die gegen den mittleren, mit der Montagewand bestückten Schrankteil hochfrequenzdicht geschirmt sind.

Als Filterbaugruppen, die den vorstehenden Fordergruppen genügen, eignen sich Baugruppen, bestehend aus einer doppelseitig durchkontaktierten ersten Leiterplatte als Träger der elektrischen Filterbauelemente, die — betrachtet in Filterdurchlassrichtung — filtereingangsseitig eine zur Leiterplatte parallele Eingangsanschlussleiste trägt und filterausgangsseitig an den Flansch angeflanscht ist, durch den die Durchführungselemente zu einer auf den Flansch befestigten zweiten Leiterplatte geführt sind, die auf ihrer zum Flansch abgekehrten Seite eine zur ersten Leiterplatte parallele Ausgangsanschlussleiste trägt.

Durch den Aufbau dieses Filters erübrigt sich nicht nur ein Filtergehäuse je Filterbaugruppe; die zu den Leiterplatten parallele Ausrichtung der Ein- und Ausgangsanschlussleisten, bei denen es sich üblicherweise um Rangierleisten handelt, ermöglicht zudem die mühelose Auswechslung der in die Rangierleisten eingesetzten Überspannungsschutzelemente.

Weitere Einzelheiten der Erfindung sind aus der Zeichnung ersichtlich. Es zeigt:

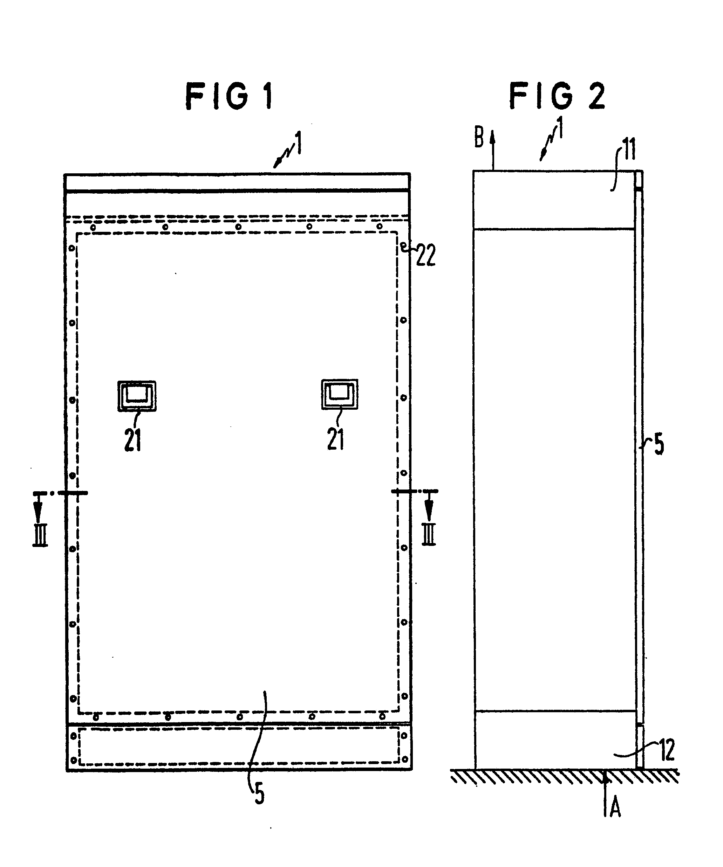

Fig. 1 einen geschirmten Schrank in Vorderansicht,

Fig. 2 den Schrank nach Fig. 1 in Seitenansicht,

Fig. 3 einen Schnitt gemäss der Linie 3-3 nach Fig. 1, wobei zur Veranschaulichung lediglich eine Filter-Baugruppe dargestellt und die Kunderverkabelung ein- und ausgangsseitig nur angedeutet ist,

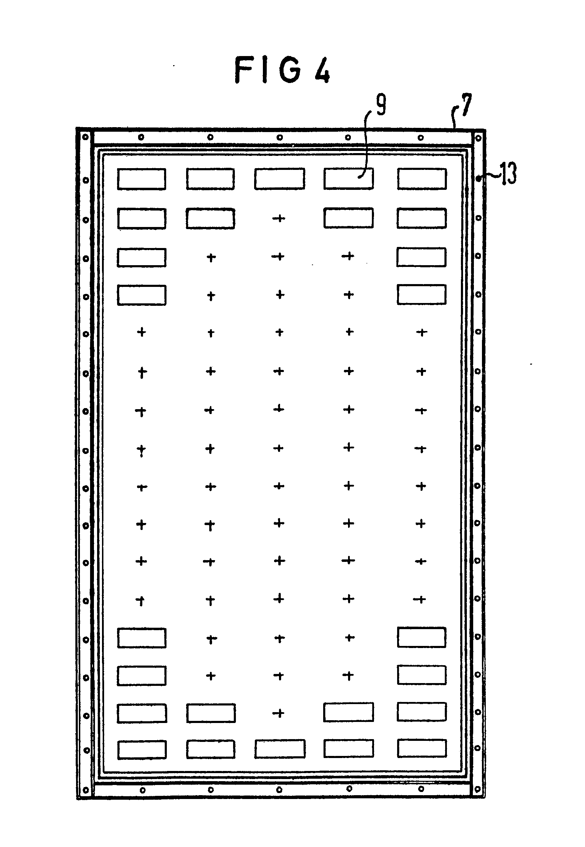

Fig. 4 die Montagewand nach Fig. 3 in Vorderansicht, wobei nur einige Durchbrechungen dargestellt sind,

Fig. 5 ein Ausführungsbeispiel einer an die Montagewand nach Fig. 4 angeflanschten Filter-Baugruppe nach der Erfindung in teilweise gebrochener und geschnittener Seitenansicht,

Fig. 6 in der Darstellung nach Fig. 5 eine Draufsicht auf die Filterbaugruppe nach Fig. 5, wobei zur Veranschaulichung Teile der Baugruppe entfernt sind,

Fig. 7 ein Beispiel für eine Beschaltung einer EMPgeschützten Nachrichten- bzw. Steuerleitung für eine Filter-Baugruppe gemäss Fig. 5 und 6.

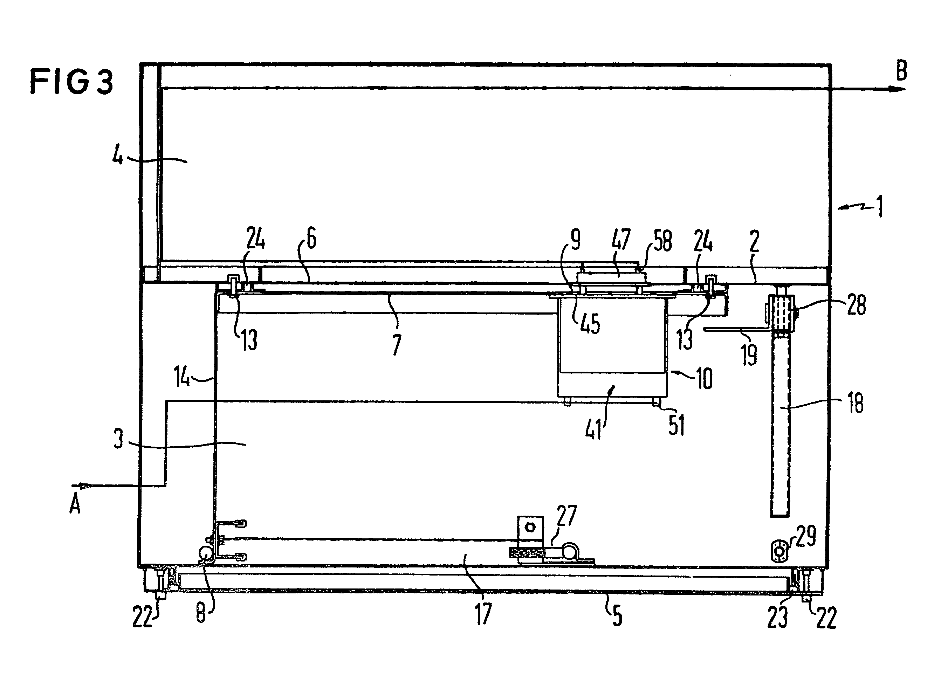

Der üblicherweise aus Stahl gefertigte, im folgenden als Filterschränk bezeichnete, geschirmte Schrank 1 besitzt Kabelrangierräume 11, 12 und ist durch einen mit den Schrankwänden hochfrequenzdicht verbundenen Rahmen 2 (siehe Fig. 3) in eine Kabelein- und Kabelausgangsseite 3 bzw. 4 unterteilt. Die Kabeleingangsseite 3 ist durch eine mittels Schrauben 22 mit dem Schrank 1 verschraubte, mit Griffen 21 ausgestattete Frontblende hochfrequenzdicht abgedeckt. Als hochfrequente Dichtung dient dabei eine HF-Dichtungsschnur 23, die gegen entsprechende Federn anliegt.

Mit 7 ist eine mit Durchbrechungen 9 für die Filter-Baugruppen 10 ausgebildete Montagewand bezeichnet, die im Betriebszustand des Filterschranks hochfrequenzdicht mittels Schrauben 13 mit dem Rahmen 2 verschraubt ist. Die hochfrequente Dichtung wird dabei mittels HF-Dichtungsschnüren 24 bewerkstelligt, die in entsprechende Nuten eingelegt sind.

Die Montagewand 7 ist über eine senkrecht zu ihr ausgerichtete Wand 14 an eine Drehachse 8 angelenkt. An die Wand 14 ist im Bereich der Drehachse 8 eine zur Wand 14 senkrechte Stütze 17 angeschraubt, die einen um 90° schwenkbaren Fuss 27 aufweist. Zusätzlich ist eine um eine Drehachse 28 schwenkbare Stütze 18 vorgesehen, an die ein Sicherungsbügel 19 angelenkt ist, der die gelöste Montagewand 7 gegen Schwenken sichert und erst freigibt, wenn die um die Drehachse 28 geschwenkte Stütze 18 mit einer am Filterschrankboden angeordneten Mutter 29 verschraubt ist.

Bevor die Montagewand 7 geschwenkt werden kann, muss folglich zunächst die Frontblende 5 und die Montagewand 7 gelöst und anschliessend die Stütze 18 in die Stützstellung befördert werden, die den Filterschränk gegen Kippen sichert. Die Sicherung der nach aussen geschwenkten Montagewand 7 erfolgt letztlich durch die Stütze 17, 27, deren um 90° nach unten geschwenktes Teil 27 sich gegen den Boden abstützt.

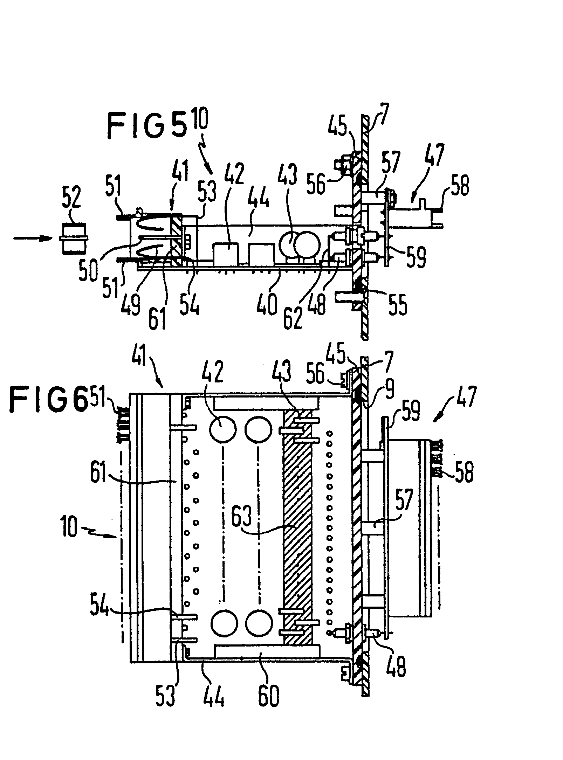

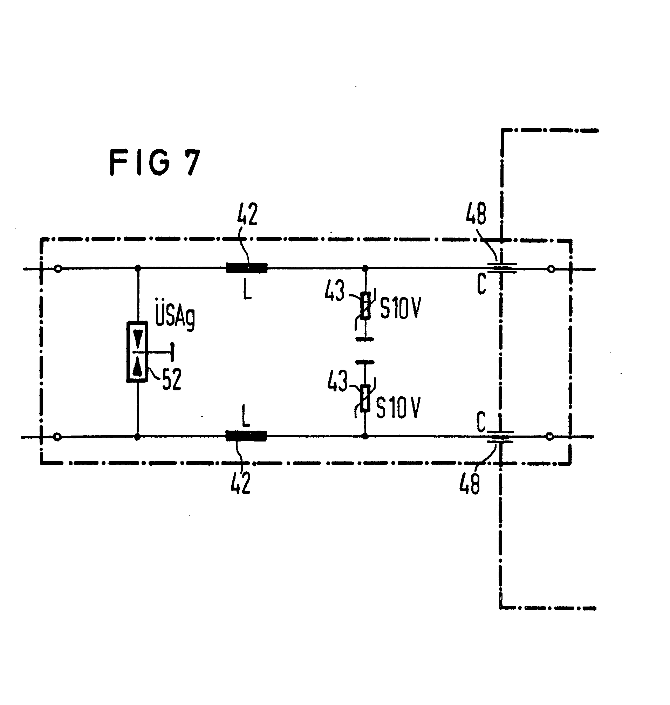

Die in Fig. 3 dargestellte Filter-Baugruppe 10, von der ein mögliches Ausführungsbeispiel in Fig. 5 und 6 dargestellt ist, besitzt eine doppelseitig durchkontaktierte erste Leiterplatte 40 als Träger elektrischer Drosseln 42 und Varistoren 43, die z.B. gemäss dem Schaltbild nach Fig. 7 geschaltet sind. Betrachtet in Filterdurchlassrichtung ist filtereingangsseitig eine zur Leiterplatte 40 parallele Eingangsanschlussleiste 41 angeordnet, die eine mit Durchbrechung für die Kontaktelemente 53, 54 ausgestattete Isolierleiste 61 aufweist. Diese an sich bekannte, in ihrem rückwertigen Teil lediglich durch diese Isolierleiste ersetzte Rangier- bzw. Eingangsanschlussleiste 41 ist mit einem durchlaufenden Masseleiter 50 und je anzuschliessender Doppelader mit zwei Schneidklemmkontakten 51 mit zwischengeschalteten Federkontakte 49 ausgerüstet. Die Schneidklemmkontakte 51 ermöglichen dabei eine lötfreie Kontaktierung der Leitungen der Eingangskabel mit der Eingangsanschlussleiste 41. Die Federkontakte 50 hinwiederum gestatten die lötfreie Schaltung von Überspannungsschutz-Elementen, insbesondere Knopfvaristoren, Einzel- oder 3-Elektrodenableitern 52 zwischen die Schneidklemmkontakte 51.

Die Leiterplatte 40 ist mit ihrem von der Eingangsanschlussleiste 41 abgekehrte Ende an einen Metallflansch 45 angeflanscht, durch den Filterdurchführungselemente, z.B. Durchführungskondensatoren 48 oder Durchführungsfilter zu einer mittels Abstandshaltern 57 am Flansch 45 befestigten zweiten Leiterplatte 59 geführt sind. Die Filterdurchführungselemente 48 sind mit ihren einen Enden mittels Kontaktelementen 62 mit den entsprechenden Leiterbahnen der ersten Leiterplatte 40 kontaktiert.

Die Leiterplatte 40 ist an Winkelelementen 60 parallel geführter Bügel 44 befestigt, deren Enden mit dem Flansch 45 bzw. mit der Eingangsanschlussleiste 41 verbunden sind. Die Leitertplatte 40 ist dabei mit einem gemeinsamen, grossflächigen, d.h. breitbandigen Masseanschluss 63 für die Varistoren 43 belegt, der über die Winkelelemente 60 und ihre Bügel 44 mit dem Masseleiter 50 der Eingangsanschlussleiste 41 und dem Flansch 45 kontaktiert ist. Hierdurch wird die Möglichkeit zur Ableitung hoher Störströme zum Flansch 45 und damit zur Montagewand 7 des Filterschranks 1 geschaffen.

Der Flansch 45 ist mit nichtbezeichneten Bohrungen versehen, durch die mittels Schraubverbindungen 56 die einzelne Filter-Baugruppe 10 an die Montagewand 7 angeflanscht werden kann. Auf seiner zur Montagewand 7 gekehrten Seitenfläche ist in entsprechende Nuten des Flansches 45 eine HF-Dichtungsschnur 55 eingelegt, die eine HF-dichte Verbindung des Flansches 45 mit der Montagewand 7 gewährleistet. An die zweite Leiterplatte 59, die mit ihren Abstandshaltern 57 und den Filterdurchführungselementen 48 durch die Ausnehmung 9 der Montagewand HF-dicht geführt ist, ist auf der vom Flansch 45 abgekehrten Seite eine Ausgangsanschlussleiste 47 befestigt. Diese Leiste ist gleichfalls eine an sich bekannte lötfreie Anschlussleiste, die je Doppelader zwei Schneidklemmkontakte 58 besitzt.

Ein beispiel für eine geeignete, bekannte Schaltung für eine Filterbaugruppe 10 für EMP-geschützte Nachrichten- und Steuerleitungen zeigt Fig. 7. Die lediglich für eine Doppel- ader dargestellte Schaltung ist eine reine EMP-Schutzschaltung mit minimaler Einfügungsdämpfung. Als Überspannungsschutzelement ist ein 3-Elektroden-Ableiter 52 vorgesehen. Varistoren 43, Durchführungskondensatoren 48 und Induktivitäten 42, die z.B. Filterspulen mit RM-Ferritkernen sind, ergänzen die Schaltung. Die dargestellte Schaltung ist lediglich ein Ausführungsbeispiel für eine mögliche Schaltung. Es sind auch Schaltungen denkbar, die sich durch höhere Dämpfungswerte, durch Feinschutz mittels Zener-Dioden, Suppressor-Diode und dergleichen auszeichnen.

Der beschriebene Filterschrank und die beschriebenen Filter-Baugruppen eignen sich zur Schaffung eines Filterschranks mit hoher Leitungs- bzw. Packungsdichte. So können beispielsweise Filterschränke mit Filter-Baugruppen für 800 Doppeladern erstellt werden. Die Kabelrangierräume gewährleisten darüberhinaus eine äusserst flexible Kabelzu- und Abführung, was die Montage und Verdrahtung erheblich vereinfacht.

## Patentansprüche

1. Geschirmter Schrank mit Filter-Baugruppen, insbesondere für EMP-geschützte und ggf. entstörte Nachrichten- und Steuerleitungen, die zur Einführung in geschirmte Räume und Kabinen bestimmt sind, dadurch gekennzeichnet, dass der Schrank (1) durch einen mit den Schrankwänden hochfrequenzdicht verbundenen Rahmen (2) in eine Kabelein- und hochfrequenzdichte Kabelausgangsseite (3, 4) unterteilt ist, dass die Kabeleingangsseite (3) des Schranks durch eine hochfrequenzdichte, lösbare Frontblende (5) abgedeckt ist, dass gegen die Rahmenöffnung (6) hochfrequenzdicht eine um eine Drehachse (8) nach aussen schwenkbare, mit Durchbrechungen (9) ausgebildete Montagewand (7) für die Filter-Baugruppen (10) anliegt, dass die einzelnen Filter-Baugruppen gehäusefrei sind und mit ihren Filterausgangsseiten durch die Durchbrechungen (9) geführt und an die Montagewand (7) mittels Flanschen (45) hochfrequenzdicht angeflanscht sind, die als Träger der Filterbaugruppen dienen und mit Durchführungselementen (48) zur hochfrequenzdichten Verbindung der Filterein- und Ausgangsseiten bestückt sind.

2. Geschirmter Schrank nach Anspruch 1, dadurch gekennzeichnet, dass am Kopf- und Fussende des Schranks (1) hochfrequenzdicht gegen den mittleren Schrankteil geschirmte Kabelrangierräume (11, 12) ausgebildet sind.

3. Geschirmter Schrank nach Anspruch 1, dadurch gekennzeichnet, dass die Montagewand (7) mittels Schrauben (13) lösbar mit dem Rahmen (2) verbunden ist.

4. Geschirmter Schrank nach Anspruch 1, dadurch gekennzeichnet, dass die Montagewand (7) über eine senkrecht zu ihr ausgerichtete Wand (14) an die Drehachse (8) angelenkt ist und dass im Bereich der Drehachse an dieser Wand eine Stütze (17) befestigt ist, die bei ausgeschwenkter Montagewand den Schrank den Schrank (1) gegen Kippen sichert.

5. Geschirmter Schrank nach Anspruch 1 und 4, dadurch gekennzeichnet, dass gegen die veschraubte Montagewand (7) ein mit einer zweiten Stütze (18) verbundener Sicherungsbügel (19) anliegt, der bei Stützstellung der Stütze die Montagewand freigibt.

6. Geschirmter Schrank nach Anspruch 1 bis 5, gekennzeichnet, durch Filterbaugruppen (10) bestehend aus einer doppelseitig durchkontaktierten ersten Leiterplatte (40) als Träger der elektrischen Filterbauelemente (42, 43), die — betrachtet in Filterdurchlassrichtung — filtereingangsseitig eine zur Leiterplatter parallele Eingangsanschlussleiste (41) trägt und filterausgangsseitig an den Flansch (45) angeflanscht ist, durch den die Durchführungselemente (48) zu einer auf den Flansch befestigten zweiten Leiterplatte (59) geführt sind, die auf ihrer zum Flansch abgekehrten Seite eine zur ersten Leiterplatte parallele Ausgangsanschlussleiste (47) trägt.

7. Geschirmter Schrank nach Anspruch 1 und 6, dadurch gekennzeichnet, dass die Flansche (45) der Filterbaugruppen (10) zur Schraubverbindung (56) der Filterbaugruppen mit der Montagewand (7) Bohrungen aufweisen.

8. Geschirmter Schrank nach Anspruch 1, 6 und 7, dadurch gekennzeichnet, dass die Flansche (45) der Filterbaugruppen (10) auf ihren zur Montagewand (7) gekehrten Seitenflächen Hochfrequenzdichtungen, insbesondere Hochfrequenzdichtungsschnüre (55) tragen.

**Claims**

1. A screened cabinet with filter modules, in particular for EMP-protected and possibly interference-suppressed communication and control lines which are intended for introduction into screened rooms and cubicles, characterized in that the cabinet (1) is divided into a cable input side and a high-frequency sealed cable output side (3, 4) by a frame (2) fixed to the cabinet walls in a high-frequency sealed connection; in that the cable input side (3) of the cabinet is covered by a high-frequency sealed, detachable front panel (5); in that an assembly wall (7) which can be swung outwards about a rotary axis (8) and is designed with apertures (9) for the filter modules (10) lies high-frequency sealed against the frame opening (6); in that the individual filter modules are without a housing and are led through the apertures (9) with their filter output sides and are flange-mounted with a high-frequency seal on the assembly wall (7) by means of flanges (45) which serve as bearers of the filter modules and are equipped with feed-through elements (48) for a high-frequency sealed connection of the filter input and output sides.

2. A screened cabinet according to Claim 1, characterized in that there are cable wiring compartments (11, 12) which are screened and high-frequency sealed from the middle part of the cabinet at the top and bottom end of the cabinet (1).

3. A screened cabinet according to Claim 1, characterized in that the assembly wall (7) is connected detachably to the frame (2) by means of screws (13).

4. A screened cabinet according to Claim 1, characterized in that the assembly wall (7) is hinged along the rotary axis (8) via a wall (14) which is vertical to the assembly wall and in that there is fixed to this wall in the area of the rotary axis a support (17) which prevents the cabinet (1) from tipping over when the assembly wall is swung out.

5. A screened cabinet according to Claims 1 and 4, characterized in that a safety bracket (19) connected to a second support (18) lies against the screwed-on assembly wall (7), which safety bracket releases the assembly wall when the support is in the support position.

6. A screened cabinet according to Claims 1 to 5, characterized in that there are filter modules (10) consisting of a first two-sides through connected circuit board (40) as bearer of the electric filter components (42, 43) and which bears on the filter input side — viewed in the filter throughput direction — an input terminal block (41) parallel to the circuit board and which is flange-mounted at the filter output side on the flange (45), through which the feed-through elements (48) are led to a second circuit board (59) which is fixed on the flange and bears an output terminal block (47) parallel to the first circuit board on its side facing away from the flange.

7. A screened cabinet according to Claims 1 and 6, characterized in that the flanges (45) of the filter modules (10) have bores for the screw connection (56) of the filter modules to the assembly wall (7).

8. A screened cabinet according to Claims 1, 6 and 7, characterized in that the flanges (45) of the filter modules (10) bear on their side surfaces facing the assembly wall (7) high-frequency sealing elements, in particular high-frequency sealing strips (55).

**Revendications**

1. Armoire blindé comportant des modules de filtres, notamment pour des lignes de transmission d'informations et des lignes de commande, protégées contre les perturbations électromagnétiques et éventuellement déparasitées, qui sont destinées à pénétrer dans des espaces et des cabines blindées, caractérisé par le fait que l'armoire (1) est subdivisée par un cadre (2) relié e façon étanche à la haute fréquence aux parois de l'armoire, en un côté (3) d'entrée des câbles et en un côté (4) de sortie des câbles, étanche à la haute fréquence, que le côté (3) d'entrée des câbles de l'armoire est fermé par un panneau avant amovible (5), étanche à la haute fréquence, qu'une paroi de montage (7) prévue pour les modules de filtres (10), pouvant pivoter vers l'extérieur autour d'un axe de rotation (8) et comportant des perçages (9), est appliquée d'une manière étanche à la haute fréquence contre l'ouverture (6) du cadre, que les différents modules de filtres sont séparés du boîtier, s'étendent, par leurs côtés de sortie de filtre, à travers les perçages (9) et sont raccordés à la paroi de montage (7), d'une manière étanche à la haute fréquence, au moyen de brides (45), qui servent de supports des modules de filtres et sont pourvues d'éléments de traversée (48) servant à relier, d'une manière étanche à la haute fréquence, les côtés entrée et sortie des filtres.

2. Armoire blindée suivant la revendication 1, caractérisée par le fait qu'à l'extrémité de tête et à l'extrémité de base de l'armoire (1) il est prévu des espaces (11, 12) de rangement des câbles, espaces qui sont protégés d'une manière étanche à la haute fréquence vis-à-vis de la partie centrale de l'armoire.

3. Armoire blindée suivant la revendication 1, caractérisée par le fait que la paroi de montage (7) est reliée de façon détachable au cadre (2) au moyen de vis (13).

4. Armoire blindée suivant la revendication 1, caractérisée par le fait que la paroi de montage (7) est articulée au-dessus d'une paroi (14), qui est perpendiculaire à la précédente, au niveau de l'axe de rotation (8) et qu'au voisinage de l'axe de rotation se trouve fixé, dans cette paroi, un support (17) qui empêche tout basculement de l'armoire (1) lorsque la paroi de montage est écartée par basculement.

5. Armoire blindée suivant les revendications 1 et 4, caractérisée par le fait qu'un étrier de sécurité (19), qui est relié à un second support (18) et libère la paroi de montage lorsque le support est dans la position de soutien, est appliqué contre la paroi de montage vissée (7).

6. Armoire blindée suivant les revendications 1 à 5, caractérisée par des modules de filtres (10) constitués par une première plaquette à circuits imprimés (40) munie de contacts sur ses deux faces et constituant le support des composants électriques des filtres (42, 43), qui — lorsque l'on regarde dans la direction de traversée des filtres — porte, sur le côté entrée des filètres, une barrette de connexion d'entrée (41) parallèle à la plaquette à circuits imprimés et est raccordé, sur le côté sortie des filtres, à la bride (45) que traversent les éléments de traversée (48) aboutissant à une seconde plaquette à circuits imprimés (59), qui est fixée sur la bride et porte, sur sa face tournée à l'opposé de la bride, une barrette de connexion de sortie (47) parallèle à la première plaquette à circuits imprimés.

7. Armoire blindée suivant les revendications 1 et 6, caractérisée par le fait que la bride (45) des modules de filtres (10) comporte des perçages permettant la fixation par vissage (56) des composants de filtrage à la paroi de montage (7).

8. Armoire blindée suivant les revendications 1, 6 et 7, caractérisée par le fait que les brides (45) des modules de filtres (10) portent, sur leurs faces latérales tournées vers la paroi de montage (7), les éléments d'étanchéité à la haute fréquence, notamment des cordons d'étanchéité à la haute fréquence (55).

# FIG 1

# FIG 2

FIG 3

0 162 146

# FIG 4

FIG 5

FIG 6

# FIG 7